# EUROPEAN PATENT APPLICATION

(11) **EP 4 510 451 A1**
(43) Date of publication of application: **19.02.2025**
(21) Application number: 23191662.8
(22) Date of filing: 16.08.2023
(51) Int. Cl.: H03K 17/082

(54) **DEVICE INCLUDING POWER TRANSISTOR**

(71) Applicant: Infineon Technologies AG, 85579 Neubiberg (DE)
(72) Inventor: ROSTEK, Johannes, 59494 Soest (DE); NORLING, Karl Egil, 9500 Villach (AT); MIATTON, Daniele, 27020 Carbonara al Ticino (IT)
(74) Representative: Kraus & Lederer PartGmbB

(57) **Abstract**

Devices including a power transistor having a control terminal coupled to a control node are provided. A supply circuit is coupled to the control node comprising an output capacitor and configured to provide a supply voltage at the output capacitor to supply a further circuit.

## Description

### BACKGROUND

The present application relates to devices including power transistors.

Power transistors are used in various applications to switch electrical power (i.e. currents and voltages), for example high currents up to several hundred ampere or high voltages up to several thousand volts. The term "power transistor" as used herein also includes transistors where a plurality of transistor cells are coupled in series, for example stacked, to increase voltage handling capabilities or coupled in parallel to increase current handling capabilities.

Power transistors may be provided in a package together with a further circuit. Such a further circuit may include a circuit which monitors a current through the power transistor to detect an overcurrent, and possibly take countermeasures like switching the power transistor off in case of an overcurrent, or other diagnostic circuits. Such a further circuit may need a power supply to be able to operate.

Examples for such devices are described in US 2017/288385 A1, JP 2005-020843 A or are implemented in the M17561L-01 hybrid IC by Ishaya Electronics Corporation.

### SUMMARY

A device as defined in claim 1, 9 or 13 is provided. The dependent claims define further embodiments.

According to a first aspect, a device is provided, comprising:
a power transistor comprising a first load terminal, a second load terminal and a control terminal,
a device control node coupled to the control terminal,
a supply circuit coupled to the device control node comprising:
   a rectifier arrangement coupled between the device control node and an input side of a charge pump,
   wherein an output side of the charge pump is coupled to an output capacitor,
   wherein the supply circuit is configured to provide a supply voltage at the output capacitor, and
a further circuit configured to be supplied by the supply voltage.

According to a second aspect, a device is provided, comprising:
a power transistor comprising a first load terminal, a second load terminal and a control terminal,
a device control node coupled to the control terminal,
a supply circuit coupled to the device control node and comprising at least an output capacitor and at least one diode coupled between the device control node and the output capacitor, wherein the supply circuit is configured to provide a supply voltage at the output capacitor,
wherein the control node is further coupled to a first terminal of an auxiliary switch, wherein a second terminal of the auxiliary switch is coupled to the control terminal of the power transistor,
wherein the auxiliary switch is configured to be on only after the supply voltage has reached a predefined level, wherein the device further comprises a further circuit configured to be supplied by the supply voltage.

According to a third aspect, a device is provided, comprising:
a power transistor comprising first load terminal, a second load terminal and a control terminal,
a device control node coupled to the control terminal,
a supply circuit coupled to the device control node comprising at least an output capacitor and at least one diode coupled between the device control node and the output capacitor, wherein the supply circuit is configured to provide a supply voltage at the output capacitor,
wherein the control node is further coupled to a first terminal of an auxiliary switch, wherein a second terminal of the auxiliary switch is coupled to the control terminal of the power transistor,
wherein the device comprises a further circuit configured to be supplied by the supply voltage and comprising a safety circuit configured to detect an error condition related to the power transistor and to switch off the auxiliary switch in response to detecting the error condition.

The above summary merely gives an overview over some embodiments and is not to be construed as limiting in any way.

### BRIEF DESCRIPTION OF THE DRAWINGS

Fig. 1 is a block diagram of a device according to an embodiment.
Fig. 2 is a diagram of a device according to a further embodiment.
Figs. 3A and 3B illustrate the behavior of some examples.
Fig. 4 is a diagram of a device according to an embodiment.
Fig. 5 is a circuit diagram of a device according to an embodiment.
Fig. 6 is a diagram illustrating an example operation of the device of Fig. 5.
Fig. 7 is a circuit diagram of a device according to a further embodiment.
Fig. 8 is a circuit diagram of a device according to another embodiment.
Fig. 9 is a signal diagram illustrating operation of the embodiment of Fig. 8.

### DETAILED DESCRIPTION

In the following, various embodiments will be described referring to the attached drawings. These embodiments are given by way of example only and are not to be construed as limiting.

Variations and modifications described with respect to one of the embodiments also applicable to other embodiments and will therefore not be described repeatedly. Features, for example elements, components, acts, events, circuit parts etc. from various embodiments may be combined to form further embodiments.

Connections or couplings shown in the drawings or described herein refer to electrical connections or couplings unless noted otherwise. Such connections or couplings may be modified, for example by adding additional elements or by modifying elements, as long as the general purpose of the connection or coupling, for example to provide a voltage or current, to transmit a signal, to provide a control etc. are essentially maintained. In other words, if it is stated that a first element is connected or coupled with a second element, this does not exclude the presence of intervening elements between the first and second element. The statement "directly coupled" or "directly connected" indicates that no intervening elements are present.

A transistor as used herein is generically described as comprising a control terminal and at least two load terminals. In case of a field effect transistor like a MOSFET, the control terminal is the gate terminal, and the load terminals include the source and drain terminals. As an additional load terminal, for example an auxiliary source terminal or an auxiliary drain terminal may be present. In case of an insulated gate bipolar transistor (IGBT), the control terminal is the gate terminal and the load terminals include the emitter and collector terminals. Also here, an auxiliary load terminal like an auxiliary emitter terminal or an auxiliary collector terminal, may be provided. In case of a bipolar junction transistor (BJT), the control terminal is the base terminal, and the load terminals include the collector and emitter terminals. Again, auxiliary terminals may be additionally provided. While field effect transistors are used as examples in some of the embodiments described below, it is to be understood that in other embodiments other types of transistors may be used.

In the figures, like elements are designated with the same reference numerals and will not be described repeatedly.

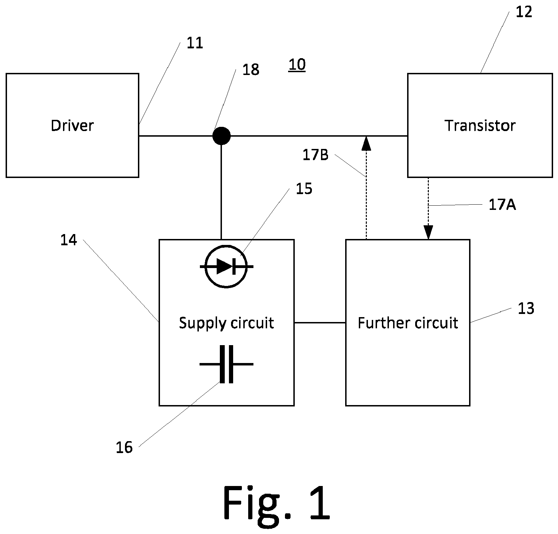

Fig. 1 is a block diagram of device 10 according to an embodiment. Device 10 of Fig. 1 is used as a generic example for various embodiments.

Device 10 of Fig. 1 comprises a power transistor 12, which in operation may be used to switch currents and voltages, between its load terminals in various applications.

A control terminal of transistor 12 is coupled to a driver 11. The term gate driver will be used for driver 11 in the following, with the understanding that if the corresponding transistor is a bipolar junction transistor, the driver is a base driver.

A control node between gate driver 11 and transistor 12 is coupled to a supply circuit 14. Supply circuit 14 comprises at least one diode 15, for example a plurality of diodes forming a rectifier, and at least one capacitor 16. Based on a voltage output by gate driver 11 for driving transistor 12, supply circuit 14 generates a supply voltage Vsupply at capacitor 16, to supply a further circuit 13 with power. Capacitor 16 in some embodiments may serve as an energy storage, to continuously supply further circuit 13 also in case a voltage output by gate driver 11 is switched on and off in regular intervals, to switch transistor 12 on and off. Capacitor 16 as well as capacitors of embodiments described further below may be an integrated capacitor integrated for example together with the further circuit on a chip die, or an external discrete capacitor like a ceramic capacitor or a silicon capacitor, and/or may also comprise an array of a plurality of capacitors.

Further circuit 13 may be a diagnostic and/or monitoring circuit for power transistor 12. As will be described further below, further circuit 13 may measure parameters of power transistor 12 as indicated by an arrow 17A, for example a current through power transistor 12, a temperature associated with power transistor 12, or a voltage associated with power transistor 12. Further circuit 13 may be configured to detect an error condition associated with power transistor 12, for example an overcurrent, an overvoltage or an overtemperature. In case such an error condition is detected, further circuit 13 may be configured to set device 10 to a safe state. A safe state of device 10 means, for example, a state in which the power transistor 12 is protected from damage or destruction due to an overcurrent, overvoltage or overtemperature.

As also will be explained further below, further circuit 13 may open an auxiliary switch to decouple gate driver 11 from transistor 12 to set device 10 to such a safe state. Furthermore, further circuit 13 may comprise an auxiliary gate driver which then controls power transistor 12 to be fully switched off, or to be partially switched off with a certain resistance, to mitigate the effects of an overcurrent or overvoltage condition. In some implementations, further circuit 13 may be a conventional safety circuit monitoring operation of transistor 12 and detecting an error condition. Arrow 17B represents how further circuit 13 may control device 10, for example in response to an error condition to set device 10 to a safe state.

In some embodiments, power transistor 12, further circuit 13 and supply circuit 14 may be integrated in a common package on or more chip dies. For such packages, in some embodiments the only terminals may be a control terminal coupled to control node 18 and terminals coupled to load terminals of transistor 12, but no further terminals. In some embodiments, this reduces the pin count for the package. Still, in other embodiments, additional terminals, for example for diagnostic purposes, may be present.

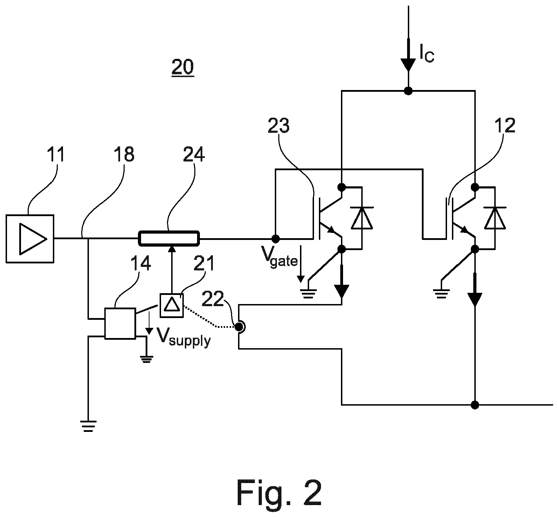

Fig. 2 illustrates a system 20 according to a further embodiment.

System 20, as power transistor 12, includes an insulated gate bipolar transistor with a freewheeling diode as shown. Other transistor types like MOSFETs may also be used.

A gate terminal of power transistor 12 is coupled to gate driver 11. Also, as in Fig. 1, a supply circuit 14 is coupled to control node 18.

Supply circuit 14 supplies a further circuit 21, which in this case performs a current monitoring. For current monitoring, device 20 comprises a sense transistor 23 coupled in parallel to power transistor 12. A sense transistor usually refers to a scaled down version of power transistor 12, such that a current flowing through sense transistor 23 also is scaled with respect to the current flowing through power transistor 12. The scaling factor may be large, for example 1:100 or more, such that the greatest part of the current flows through power transistor 12. However, other scaling factors may also be used, or no scaling may be used. Sense transistor 23 is commonly controlled with power transistor 12, i.e. also the gate terminal of sense transistor 23 is driven by gate driver 11, as shown in Fig. 2. For this, in a package a common gate pin may be provided to which gate driver 11 supplies a control signal. This control signal is then provided to the gate terminals of sense transistor 23 and power transistor 12.

The current through sense transistor 23 is measured via a current measurement device 22. Current measurement device 22, for example, may include a shunt resistor or a magnetic field based current sensing element, like a Hall sensor or magnetoresistance based sensor (generically referred to as XMR sensors, like GMR (giant magnetoresistance), TMR (tunneling magnetoresistance) etc.). In other embodiments, sense transistor 23 may be omitted, and the current flowing through power transistor 12 may be measured, for example at an emitter or auxiliary emitter thereof, using e.g. the above techniques (shunt resistor or magnetic field based current sensing).

Further circuit 21 may for example compare the measured current, which is indicative of the current through power transistor 12, with a threshold value. In case the current exceeds the threshold value, further circuit 21 opens an auxiliary switch 24 provided between control node 18 and gate terminal of power transistor 12. Auxiliary switch 24 in this case may be a normally-on transistor, i.e. a transistor which is in an on-state in the absence of a certain gate voltage being provided, therefore electrically coupling gate driver 11 to power transistor 12 (and auxiliary transistor 23) .. For example, auxiliary switch 24 may be implemented as a depletion MOSFET. In case of an error condition, as mentioned above, auxiliary switch 24 is opened, thus decoupling gate driver 11 from transistors 12, 23, switching them off. Additionally, further circuit 21, supplied by supply circuit 14, when auxiliary switch 24 is switched off may supply its own gate voltage V_{gate} to transistors 12, 23 to set them to a defined state, for example a partially on state with increased resistance in the linear region of the transistors, for example by discharging the gates of power transistor 12 (and sense transistor 23, if provided) to this gate voltage V_{gate}.

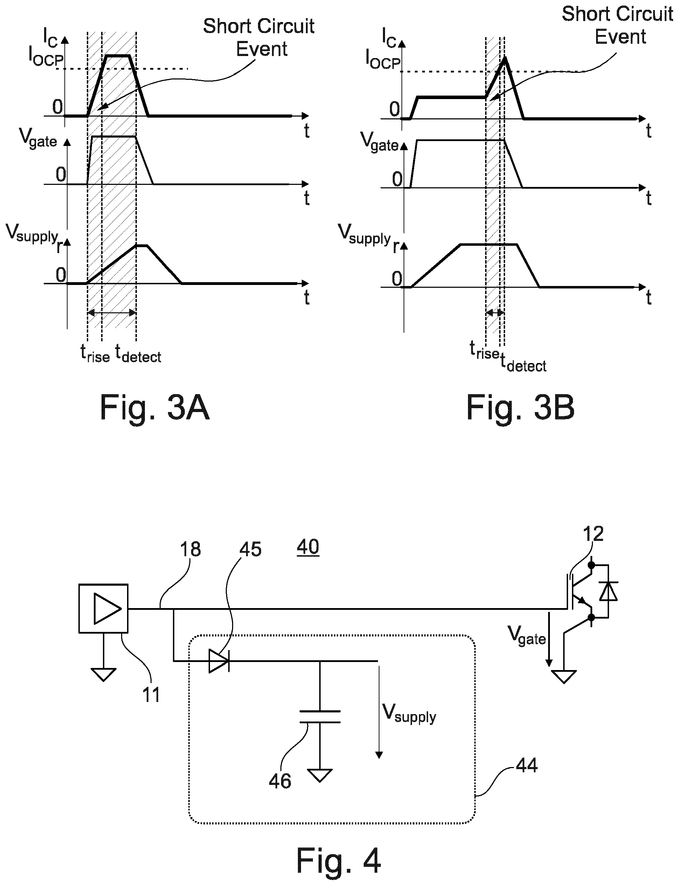

Figs. 3A and 3B are timing diagrams for illustrating effects of supply circuit 14 including capacitor 16 according to some embodiments. Figs. 3A and 3B show, for comparison purposes, conventional circuits that do not have a supply circuit as discussed herein.

Each of Figs. 3A and 3B shows an example gate voltage V_{gate} for the power transistor (like power transistor 12), where a high value corresponds to a switched-on state and a low value corresponds to a switched-off state. Furthermore, each of Figs. 3A and 3B shows an example supply voltage V_{supply} in a case without the capacitor 16, with a simple supply from node 18. Finally, I_{C} shows the current flowing through the power transistor. I_{OCP} denotes an overcurrent threshold value.

As can be seen, the supply voltage V_{supply} rises slowly after the gate voltage has reached its high state.

Fig. 3B shows a case where the power transistor is switched on, and after some time, after the supply voltage V_{supply} has reached a stationary value, a short circuit event occurs.

Upon a short circuit event, the current I_{C} rises quickly in a rise time tᵣᵢₛₑ until current threshold I_{OCP} is exceeded. Then, within a time t_{detect}, the further circuit (for example 21 of Fig. 2) detects the overcurrent and switches the power transistor off. In this case, the current I_{C} is above the threshold value only for a short time.

In contrast thereto, Fig. 3A shows a case where the short circuit event happens or is already present at switching on of the power transistor. Also in this case, the current rises immediately after switching on the power transistor. However, as in this case the power supply has not yet reached the nominal, stationary value, the further circuit (for example 21 of Fig. 2) is not yet active. For this reason, the short circuit is only detected after a much longer time t_{detect} compared to the case of Fig. 3B, which means a high current for a longer time, which may damage power transistor 12 or other circuit parts coupled to power transistor 12.

In contrast thereto, by providing capacitor 16 as an energy storage element, V_{supply} may be kept at a higher value (through the stored energy) also during times where power transistor 12 is switched off. This in turn may support an earlier detection of overcurrent events (or other events which the circuit supplied by the supply circuit detects, for example overtemperature or overvoltage) and therefore may help to reduce the probability of damage.

Next, more specific implementations of supply circuits and other elements of devices will be discussed.

Fig. 4 shows a device 40 according to a further embodiment, where a supply circuit 44 is shown in more detail. Supply circuit 44 comprises a diode 45. An anode of diode 45 is coupled to control node 18, and a cathode of diode 45 is coupled to a first terminal of an output capacitor 46. A second terminal of output capacitor 46 is coupled to ground.

When gate driver 11 outputs a positive gate voltage to control power switch 12, output capacitor 46 is charged via diode 45. The supply voltage V_{supply} in this way is built up across capacitor 46. When gate driver 11 switches off power transistor 12, for example by pulling the gate to 0 V or to negative voltages, diode 45 prevents discharging of output capacitor 46 towards control node 18, and supply voltage Vsupply is maintained.

The voltage V_{supply} then is used to supply a further circuit, for example the further circuit discussed with reference to Figs. 1 and 2 above. By using output capacitor 46, V_{supply} is maintained for a certain time even after power switch 12 or the voltage at node 18 is pulled low or gate driver 11 is even switched off, and thus when power transistor 12 is then switched on again with a short circuit event present, the further circuit may react essentially instantly, without delay as in conventional supply circuits without output capacitor 46.

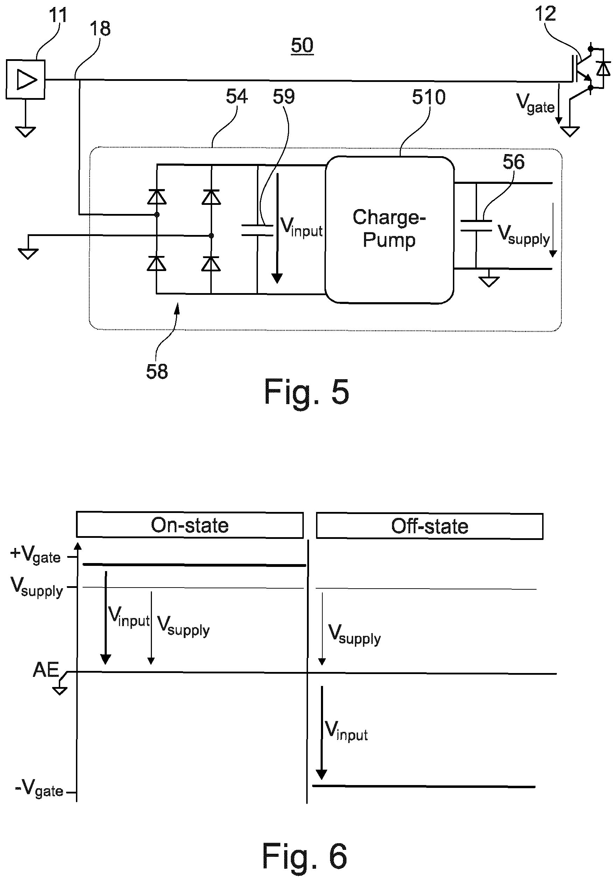

Fig. 5 illustrates a device 50 according to a further embodiment. Device 50 is particularly usable in case gate driver 11 outputs both positive and negative gate drive voltages. For example, in some implementations, a positive voltage may be used to switch power transistor 12 on, and a negative voltage may be used to switch power transistor 12 off.

In the embodiment of Fig. 5, a supply circuit 54 includes a rectifier, in case of Fig. 5 a bridge rectifier including four diodes, coupled to control node 18 and ground. The output of rectifier 58 charges an input capacitor 59 to an input voltage Vᵢₙₚᵤₜ. A charge pump 510 then converts the input voltage Vᵢₙₚᵤₜ to a voltage for charging an output capacitor 56, across which the supply voltage V_{supply} is provided, to power a further circuit as discussed above.

Fig. 6 illustrates operation of the supply circuit 54 of Fig. 5. In an on state, a positive gate voltage +V_{gate} is provided by gate driver 11 in the example shown in Fig. 6, and in an off state a gate voltage -V_{gate} is provided. An example may be a positive voltage of +15 V and a negative voltage of -15 V. While in Fig. 6 the absolute values of the positive and negative gate voltages are the same, in other embodiments the values may be different. In the on state, the input voltage Vᵢₙₚᵤₜ corresponds to V_{gate}, and is converted to V_{supply} by charge pump 510. In the off state, Vᵢₙₚᵤₜ has the same polarity as in the on state (due to the rectifier), but exhibits a common mode shift compared to the on state. In both cases, Vᵢₙₚᵤₜ is converted to the same supply voltage V_{supply} by charge pump 510 to charge output capacitor 56.

Please note that in some embodiments input capacitor 59 may be omitted, and the output of rectifier 58 may be provided directly to charge pump 510.

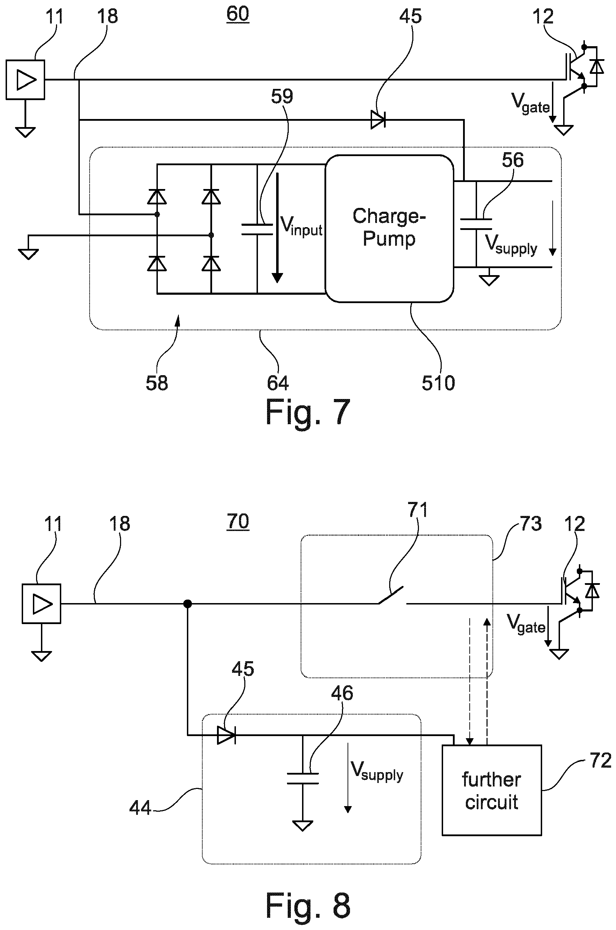

Fig. 7 shows an embodiment which is essentially a combination of the embodiments of Figs. 4 and 5. In addition to the path via rectifier 58, input capacitor 59 and charge pump 510 for charging output capacitor 56, additionally diode 45, like in Fig. 4, is provided allowing a direct charging of output capacitor 56 from control node 18 via diode 45 when the voltage output by gate driver 11 is positive. This bypass by diode 45 may in some implementations allow a faster charging when the voltage output by the gate driver is positive.

Fig. 8 illustrates a device 70 according to a further embodiment. As supply circuit in the embodiment of Fig. 8, supply circuit 44 of Fig. 4 is used. However, alternatively also supply circuit 54 of Fig. 5 or supply circuit 64 of Fig. 7 may be used.

The embodiment of Fig. 8 additionally includes a switch device 73 including an auxiliary switch 71 between gate driver 11 and power transistor 12. Auxiliary switch 71 may be a transistor switch. Unlike auxiliary switch 24 of Fig. 2, auxiliary switch 71 may be a normally-off switch, which disconnects driver circuit 11 from power transistor 12 unless a corresponding control signal is applied to auxiliary switch 71. In operation, as long as the supply voltage V_{supply} is below a threshold (for example below the stationary value shown in Figs. 3A and 3B by at least some margin), auxiliary switch 71 is open. Only once supply voltage V_{supply} is high enough to supply a further circuit 72 with power, further circuit 72 becomes operative and may act on switch device 73 to close auxiliary switch 71. Then, power switch 12 is switched on by the gate drive voltage delivered by gate driver 11. In addition to the function of turning auxiliary switch 71 on when the supply voltage V_{supply} is high enough, further circuit 72 may also include a safety circuit monitoring power transistor 12, as discussed above.

By closing auxiliary switch 71 only after power supply has reached a certain level, a situation as in Fig. 3A may be prevented in some embodiments, for example at a first switching on at start up or after a longer switch off period, where the respective output capacitor like output capacitor 46 is discharged.

It should be noted that auxiliary switch 71 is on when power transistor is to be switched off (as it was switched on before), or may include a body diode or separate diode to always allow conduction for turning power transistor 12 off.

Please note that auxiliary switch 71 may additionally have the function described with respect to auxiliary switch 24 of Fig. 2, i.e. auxiliary switch 71 may be opened by further circuit 72 upon detecting an error condition. In other embodiments, separate auxiliary switches may be provided for the two functions (disconnecting driver circuit 11 from power transistor 12 as long as V_{supply} has not exceeded a threshold on the one hand, and disconnecting driver circuit 11 from power transistor 12 in case of an error condition).

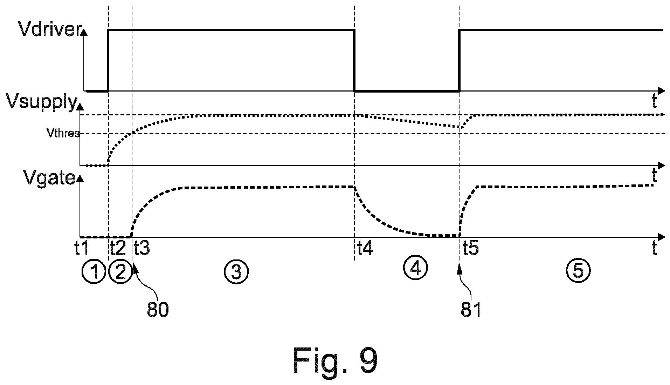

Fig. 9 is a signal diagram illustrating operation of the embodiment of Fig. 8.

In a time period 1, starting at t1 the device 70 is off. Then, at a time t2 at the beginning of a time period 2, the gate driver 11 outputs a positive voltage V_{driver}. After a certain time needed for the supply voltage Vsupply to build up and supply further circuit 72 , at the end of time period 2, marked by a dashed line 80, at time t3 when the supply voltage Vsupply crosses a threshold voltage Vthres, auxiliary switch 71 is closed, the gate voltage Vgate at power transistor 12 increases, and power transistor 12 is switched on. Therefore, at the first switching on, auxiliary switch 71 introduces a delay.

At the end of time period 3, at time t4 Vdriver goes to zero, and power transistor 12 is switched off. Due to capacitor 46, however, the voltage Vsupply only decreases very slowly and is almost at the nominal value at a next switching event at the end of time period 4 at a time t5.

Since the supply voltage is already high (and above the threshold) when gate driver 11 provides a high driving voltage, auxiliary switch 71 is already turned on, so that the gate driver output voltage is applied to the gate of transistor 12 almost instantly at dashed line 81.

It should be noted that gate driver 11 may output the gate voltage via a gate driver resistor, as is conventional for such devices.

Some embodiments are defined by the following examples:
Example 1. A device, comprising:
   a power transistor comprising a first load terminal, a second load terminal and a control terminal,
   a device control node coupled to the control terminal,
   a supply circuit coupled to the device control node,
   comprising:
      a rectifier arrangement coupled between the device control node and an input side of a charge pump, and
      wherein an output side of the charge pump is coupled to an output capacitor,
      wherein the supply circuit is configured to provide a
      supply voltage at the output capacitor, and
   a further circuit configured to be supplied by the supply voltage.
Example 2. The device of example 1, wherein the control node is further coupled to a first terminal of an auxiliary switch, wherein a second terminal of the auxiliary switch is coupled to the control terminal of the power transistor.
Example 3. The device of example 2, wherein the auxiliary switch is configured to be in an off state until the supply voltage is larger or equal to a predefined threshold voltage.
Example 4. The device of example 2 or 3,
   wherein the auxiliary switch comprises a normally off switch.
Example 5. The device of example 3 or 4, wherein the auxiliary switch includes a control terminal and is configured to be switched between an on state and an off state based on a control voltage applied to its control terminal, and wherein the further circuit is configured to control a switching state of the auxiliary switch based on the supply voltage.
Example 6. The device of any one of examples 1 to 5, wherein the further circuit is configured to monitor at least one operating condition of the power transistor.
Example 7. The device of any one of examples 1 to 6, wherein the further circuit comprises a safety circuit configured to detect an error condition related to the power transistor and to set the device to a safe state in response to detecting the error condition.
Example 8. The device of example 7 and of any one of examples 2 or 3, wherein the further circuit is configured to switch off the auxiliary switch in response to detecting the error condition.
Example 9. The device of example 8, wherein the auxiliary switch is a normally on switch.
Example 10. The device of any one of examples 1 to 9, wherein the further circuit comprises at least one of:
   - a temperature sensing circuit for sensing a temperature of the power transistor;
   - a current sensing circuit for sensing a current through the power transistor;
   - a voltage sensing circuit for sensing a voltage at the power transistor; or
   - a driver circuit for driving a transistor of the further circuit.
Example 11. The device of any one of examples 1 to 10, wherein the device is provided in a package, wherein the only terminals of the package are at most a first package terminal coupled to the device control node, a second device terminal coupled to the first load terminal of the power transistor and a third and fourth device terminal coupled to the second load terminal of the power transistor.
Example 12. The device of any one of examples 1 to 11, wherein the charge pump is configured to charge the output capacitor to provide the output voltage for both positive and negative voltages at the control node.
Example 13. The device of any one of examples 1 to 12, further comprising a driver circuit coupled to the device control node and configured to drive the power transistor.
Example 14. The device of example 13, wherein the driver circuit comprises a gate resistor.
Example 15. The device of example 13 or 14, wherein the driver circuit is configured to selectively provide a positive or negative voltage for driving the power transistor.
Example 16. The device of any one of examples 1 to 15, further comprising an input capacitor coupled between the rectifier and the charge pump.
Example 17. The device of any one of examples 1 to 16, further comprising a diode, wherein an anode of the diode is coupled to the control node and a cathode of the diode is coupled to a terminal of the output capacitor.
Example 18. A device, comprising:
   a power transistor comprising a first load terminal, a second load terminal and a control terminal,
   a device control node coupled to the control terminal,
   a supply circuit coupled to the device control node comprising at least an output capacitor and at least one diode coupled between the device control node and the output capacitor, wherein the supply circuit is configured to provide a supply voltage at the output capacitor,
   wherein the control node is further coupled to a first terminal of an auxiliary switch, wherein a second terminal of the auxiliary switch is coupled to the control terminal of the power transistor,
   wherein the auxiliary switch is configured to be in an off state until the supply voltage is larger than or equal to a predefined threshold voltage,
   wherein the device further comprises
   a further circuit configured to be supplied by the supply voltage.
Example 19. The device of example 18, wherein the auxiliary switch includes a control terminal and is configured to be switched between an on state and an off state based on a control voltage applied to its control terminal, and wherein the further circuit is configured to control a switching state of the auxiliary switch based on the supply voltage.
Example 20. The device of example 18 or 19, wherein the at least one diode comprises a first diode, wherein a cathode of the first diode is coupled to a terminal of the output capacitor.
Example 21. The device of any one of examples 18 to 20, wherein the auxiliary switch comprises a normally off switch.
Example 22. The device of any one of examples 18 to 21, wherein the further circuit is configured to monitor at least one operating condition of the power transistor.
Example 23. The device of any one of examples 18 to 22, wherein the further circuit comprises a safety circuit configured to detect an error condition related to the power transistor and to set the device to a safe state in response to detecting the error condition.
Example 24. The device of example 23, wherein the further circuit is configured to switch off the auxiliary switch in response to detecting the error condition.
Example 25. The device of any one of examples 18 to 24, wherein the further circuit comprises at least one of:
   - a temperature sensing circuit for sensing a temperature of the power transistor;
   - a current sensing circuit for sensing a current through the power transistor;
   - a voltage sensing circuit for sensing a voltage at the power transistor; or
   - a driver circuit for driving a transistor of the further circuit.
Example 26. The device of any one of examples 18 to 25, wherein the device is provided in a package, wherein the only terminals of the package are at most a first package terminal coupled to the device control node, a second device terminal coupled to the first load terminal of the power transistor and a third and fourth device terminal coupled to the second load terminal of the power transistor.
Example 27. The device of any one of examples 18 to 26, further comprising a driver circuit coupled to the device control node and configured to drive the power transistor.
Example 28. The device of example 27, wherein the driver circuit comprises a gate resistor.
Example 29. A device, comprising:
   a power transistor comprising a first load terminal, a second load terminal and a control terminal,
   a device control node coupled to the control terminal,
   a supply circuit coupled to the device control node comprising at least an output capacitor and at least one diode coupled between the device control node and the output capacitor, wherein the supply circuit is configured to provide a supply voltage at the output capacitor,
   wherein the control node is further coupled to a first terminal of an auxiliary switch, wherein a second terminal of the auxiliary switch is coupled to the control terminal of the power transistor,
   wherein the device comprises a further circuit configured to be supplied by the supply voltage,
   wherein the further circuit comprises a safety circuit configured to detect an error condition related to the power transistor and to switch off the auxiliary switch in response to detecting the error condition.
Example 30. The device of example 29, wherein the further circuit is further configured to supply a control voltage to the control terminal of the power transistor after switching off the auxiliary switch.
Example 31. The device of example 29 or 30, wherein the at least one diode comprises a first diode, wherein a cathode of the first diode is coupled to a terminal of the output capacitor.
Example 32. The device of any one of examples 29 to 31, wherein the auxiliary switch comprises a normally on switch.
Example 33. The device of any one of examples 29 to 32, wherein the further circuit comprises at least one of:
   - a temperature sensing circuit for sensing a temperature of the power transistor;
   - a current sensing circuit for sensing a current through the power transistor;
   - a voltage sensing circuit for sensing a voltage at the power transistor; or
   - a driver circuit for driving a transistor of the further circuit.
Example 34. The device of any one of examples 29 to 33, wherein the device is provided in a package, wherein the only terminals of the package are at most a first package terminal coupled to the device control node, a second device terminal coupled to the first load terminal of the power transistor and a third and fourth device terminal coupled to the second load terminal of the power transistor.
Example 35. The device of any one of examples 29 to 34, further comprising a driver circuit coupled to the device control node and configured to drive the power transistor.
Example 36. The device of example 35, wherein the driver circuit comprises a gate resistor.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A device (10, 20, 40, 50, 60, 70), comprising:
a power transistor (12) comprising a first load terminal, a second load terminal and a control terminal,
a device control node (18) coupled to the control terminal,
a supply circuit (14, 44, 54, 64) coupled to the device control node (18), comprising:
a rectifier arrangement (58) coupled between the device control node (18) and an input side of a charge pump (510), and
wherein an output side of the charge pump (510) is coupled to an output capacitor (16, 46, 56),
wherein the supply circuit (14, 44, 54, 64) is configured to provide a supply voltage (Vsupply) at the
output capacitor (16, 46, 56), and
a further circuit (13, 72) configured to be supplied by the supply voltage (Vsupply).

2. The device (10, 20, 40, 50, 60, 70) of claim 1, wherein the control node (18) is further coupled to a first terminal of an auxiliary switch (71), wherein a second terminal of the auxiliary switch (71) is coupled to the control terminal of the power transistor (12).

3. The device (10, 20, 40, 50, 60, 70) of claim 2, wherein the auxiliary switch (71) includes a control terminal and is configured to be switched between an on state and an off state based on a control voltage applied to its control terminal, and wherein the further circuit (72) is configured to control a switching state of the auxiliary switch (71) based on the supply voltage.

4. The device of any one of claims 1 to 3, wherein the charge pump (510) is configured to charge the output capacitor (56) to provide the output voltage (Vsupply) for both positive and negative voltages at the control node (18).

5. The device (10, 20, 40, 50, 60, 70) of any one of claims 1 to 4, further comprising a driver circuit (11) coupled to the device control node (18) and configured to drive the power transistor (12).

6. The device of claim 5, wherein the driver circuit (11) is configured to selectively provide a positive or negative voltage for driving the power transistor (12).

7. The device (10, 20, 40, 50, 60, 70) of any one of claims 1 to 6, further comprising an input capacitor (59) coupled between the rectifier (58) and the charge pump (510).

8. The device (10, 20, 40, 50, 60, 70) of any one of claims 1 to 7, further comprising a diode (45), wherein an anode of the diode (45) is coupled to the control node (18) and a cathode of the diode (45) is coupled to a terminal of the output capacitor (16, 46, 56).

9. A device (10, 20, 40, 50, 60, 70), comprising:
a power transistor (12) comprising a first load terminal, a second load terminal and a control terminal,
a device control node (18) coupled to the control terminal,
a supply circuit (14, 44, 54, 64) coupled to the device control node (18) comprising at least an output capacitor (16, 46, 56) and at least one diode (15, 45, 58) coupled between the device control node (18) and the output capacitor (16, 46, 56), wherein the supply circuit (14, 44, 54, 64) is configured to provide a supply voltage (Vsupply) at the output capacitor (16, 46, 56),
wherein the control node (18) is further coupled to a first terminal of an auxiliary switch (71), wherein a second terminal of the auxiliary switch (71) is coupled to the control terminal of the power transistor (12),
wherein (10, 20, 40, 50, 60, 70)the auxiliary switch (71) is configured to be in an off state until the supply voltage (Vsupply) is larger than or equal to a predefined threshold voltage,
wherein the device (10, 20, 40, 50, 60, 70) further comprises a further circuit (13, 72) configured to be supplied by the supply voltage (Vsupply).

10. The device (10, 20, 40, 50, 60, 70) of claim 9, wherein the auxiliary switch (71) includes a control terminal and is configured to be switched between an on state and an off state based on a control voltage applied to its control terminal, and wherein the further circuit (72) is configured to control a switching state of the auxiliary switch (71) based on the supply voltage.

11. The device (10, 20, 40, 50, 60, 70) of any one of claims 1 to 10, wherein the further circuit (13) comprises a safety circuit configured to detect an error condition related to the power transistor (12) and to set the device (10, 20, 40, 50, 60, 70) to a safe state in response to detecting the error condition.

12. The device (10, 20, 40, 50, 60, 70) of claim 11, wherein the further circuit (13) is configured to switch off the auxiliary switch (71) in response to detecting the error condition.

13. A device (10, 20, 40, 50, 60, 70), comprising:
a power transistor (12) comprising a first load terminal, a second load terminal and a control terminal,
a device control node (18) coupled to the control terminal,
a supply circuit (14, 44, 54, 64) coupled to the device control node (18) comprising at least an output capacitor (16, 46, 56) and at least one diode (15, 45, 58) coupled between the device control node (18) and the output capacitor (16, 46, 56), wherein the supply circuit (14, 44, 54, 64) is configured to provide a supply voltage (Vsupply) at the output capacitor (16, 46, 56),
wherein the control node (18) is further coupled to a first terminal of an auxiliary switch (71), wherein a second terminal of the auxiliary switch (71) is coupled to the control terminal of the power transistor (12),
wherein the device (10, 20, 40, 50, 60, 70) comprises a further circuit (13, 72) configured to be supplied by the supply voltage (Vsupply),
wherein the further circuit (13) comprises a safety circuit configured to detect an error condition related to the power transistor (12) and to switch off the auxiliary switch (71) in response to detecting the error condition.

14. The device (10, 20, 40, 50, 60, 70) of claim 13, wherein the further circuit is further configured to supply a control voltage to the control terminal of the power transistor (12) after switching off the auxiliary switch (71).

15. The device (10, 20, 40, 50, 60, 70) of any one of claims 1 to 14, wherein the device is provided in a package, wherein the only terminals of the package are at most a first package terminal coupled to the device control node (18), a second device terminal coupled to the first load terminal of the power transistor (12) and a third and fourth device terminal coupled to the second load terminal of the power transistor (12) .
